# EUROPÄISCHE PATENTSCHRIFT

(11) **EP 3 364 163 B1**
(45) Veröffentlichungstag und Bekanntmachung des Hinweises auf die Patenterteilung: **08.04.2020**
(21) Anmeldenummer: 17156202.8
(22) Anmeldetag: 15.02.2017
(51) Int. Cl.: G01L 3/10, G01R 33/09, H01L 41/12

(54) **MAGNETOELASTISCHER DREHMOMENTSENSOR**
MAGNETOELASTIC TORQUE SENSOR
CAPTEUR MAGNÉTO-ÉLASTIQUE DE COUPLE DE ROTATION

(43) Veröffentlichungstag der Anmeldung: 22.08.2018
(73) Patentinhaber: NCTE AG, 82008 Unterhaching (DE)
(72) Erfinder: Raths Ponce, Carlos, 81669 München (DE); Eckschlager, Florian, 85521 Riemerling (DE)
(74) Vertreter: Grünecker Patent- und Rechtsanwälte PartG mbB

(56) Entgegenhaltungen:
- EP-A1- 2 878 938
- DE-B3-102014 219 336
- DE-T2- 69 838 904

## Beschreibung

### Gebiet der Erfindung

Die Erfindung betrifft einen magnetoelastischen Drehmomentsensor und ein Verfahren zur Ermittlung eines an einer Welle anliegenden Drehmoments mit einem magnetoelastischen Drehmomentsensor.

### Stand der Technik

Stand der Technik bei der Messung von Magnetfeldänderung durch Drehmoment auf Basis der Magnetostriktion ist der Einsatz von Messspulen. Diese werden berührungslos in Relation zur einer magnetisch codierten Messwelle angebracht (parallel zur Drehachse) und erfassen Magnetfeldänderungen, die auf Grund des magnetoelastischen Effekts unter Last (inverse Magnetostriktion) auftreten. Die Magnetfeldänderung ist direkt proportional zur äußeren Krafteinwirkung und stellt den Zusammenhang mit dem Drehmoment her.

Stand der Technik bei der Drehmomentmessung mittels AMR-Sensoren ist die Erfassung eines Verdrehungswinkels. Ein AMR-Sensor ist ein Magnetfeldsensor, der basierend auf dem anisotropen magnetoresistiven Effekt (AMR-Effekt) die Magnetfeldstärke messen kann. An einem Ende der Torsionsstrecke über die das Drehmoment zu messen ist, wird ein magnetischer Multipolring angebracht, welches einem AMR-Sensor gegenübersteht. Eine Verdrehung der Torsionsstrecke führt zu einer Bewegung des Multipolrings relativ zum AMR-Sensor, wodurch sich die Richtung des Magnetfelds am Ort des Sensors ändert. Aus dem Zusammenhang zwischen dem Verdrehungswinkel und magnetischen Winkel wird dann das Drehmoment bestimmt.

Bekannte Drehmomentsensoren aus dem Stand der Technik sind in den Dokumenten DE 10 2014 219 336, DE 698 38 904 T und EP 2 878 938 beschrieben.

Die derzeit eingesetzten Verfahren weisen jedoch die im Folgenden genannten Nachteile auf.

Messspulen besitzen nur eine empfindliche Achse, denn sie können Magnetfeldänderungen nur entlang ihrer Längsachse messen. Magnetfeldänderungen in andere Richtungen sind daher nicht erfassbar. Es gehen dabei beispielsweise zusätzliche Informationen über eine externe Krafteinwirkung oder ein externes Magnetfeld verloren. Im Falle der Drehmomentmessung mittels AMR-Sensoren muss der Polring mit der Welle gekoppelt sein, was aufwändig in der Konstruktion ist.

Angesichts dieser Nachteile ist es Aufgabe der vorliegenden Erfindung, ein Verfahren zur Verfügung zu stellen, die eine bessere Erfassung von Magnetfeldänderungen und eine genauere Umrechnung in Drehmoment ermöglicht und/oder eine bauliche Vereinfachung darstellt.

### Beschreibung der Erfindung

Der Erfindung liegt die Aufgabe zugrunde die genannten Nachteile zumindest teilweise auszuräumen.

Diese Aufgabe wird durch einen magnetoelastischen Drehmomentsensor nach Anspruch 1 gelöst.

Der erfindungsgemäße magnetoelastische Drehmomentsensor umfasst eine Welle, die in einem ersten axialen Abschnitt in einer ersten Umfangsrichtung magnetisiert ist, und an die ein zu messendes Drehmoment anlegbar ist; einen ersten Magnetfeldsensor zum Erfassen eines durch den ersten Abschnitt der Welle erzeugten, vom angelegten Drehmoment abhängigen Magnetfelds außerhalb der Welle; und ist dadurch gekennzeichnet, dass der erste Magnetfeldsensor einen ersten 3D-AMR-Sensor umfasst.

Für den magnetoelastischen Drehmomentsensor liegt der Vorteil der Verwendung eines 3D-AMR-Sensors darin, dass eine durch ein an der Welle anliegendes Drehmoment hervorgerufene externe Magnetfeldänderung mit dem 3D-AMR-Sensor genauer vermessen werden kann als mit einem Sensor, der nur für das Magnetfeld in Richtung der Wellenachse empfindlich ist (Spule). Die genaue Vermessung des Magnetfeldes in 3D führt zu einer höheren Genauigkeit bei der Bestimmung des anliegenden Drehmoments. Weiterhin ergibt sich auch eine Bauraumreduktion im Vergleich zu der Spulen- oder Polringimplementierung.

Die Welle kann eine Voll- oder eine Hohlwelle sein.

Die Welle des erfindungsgemäßen Drehmomentsensors weist einen zweiten axialen Abschnitt auf, der in einer zweiten Umfangsrichtung magnetisiert ist, die gegenläufig zur ersten Umfangsrichtung ist. Dann umfasst der Drehmomentsensor weiterhin einen zweiten Magnetfeldsensor zum Erfassen eines durch den zweiten Abschnitt der Welle erzeugten, vom angelegten Drehmoment abhängigen Magnetfelds außerhalb der Welle, wobei der zweite Magnetfeldsensor einen zweiten 3D-AMR-Sensor umfasst.

Auf diese Weise kann die Genauigkeit nochmals gesteigert werden und insbesondere können konstante, vom angelegten Drehmoment unabhängige Störmagnetfelder kompensiert / heraus gerechnet werden.

Gemäß einer anderen Weiterbildung können ein oder mehrere weitere magnetisierte Wellenabschnitte mit einem oder mehreren 3D-AMR-Sensoren vorgesehen sein. Gemäß einer anderen Weiterbildung kann der erste 3D-AMR-Sensor und/oder der zweite 3D-AMR-Sensor und/oder jeder weitere 3D-AMR-Sensor bzw. eine jeweilige 3D-AMR-Sensor-Platine mittels einer Kunststoffhalterung gehaltert sein. Dies reduziert die Störmagnetfelder, die beispielsweise durch eine Magnetisierung einer ferromagnetischen Halterung durch das Erdmagnetfeld erzeugt würden. Alternativ dazu können der bzw. die Sensoren auch auf einer metallischen Halterung gehaltert sein.

Die durch den 3D-AMR-Sensor bzw. die 3D-AMR-Sensoren zu messenden Magnetfeldstärken können insbesondere im Bereich von ± 10 mT, ± 3 mT, ± 1 mT, ± 300 µT, oder ± 100 µT liegen. Daher ist der erfindungsgemäße magnetoresistive Drehmomentsensor mit einer geringen Magnetisierung der Welle betreibbar, die nur geringe Messfeldstärken hervorruft. Zum Vergleich: Die Feldstärke des Erdmagnetfeldes ist in Mitteleuropa ca. 50 µT.

Der erfindungsgemäße Drehmomentsensor umfasst eine Auswerteeinheit, die dazu ausgebildet ist, Sensorsignale von dem bzw. den 3D-AMR-Sensoren zu empfangen und aus den empfangenen Sensorsignalen ein an der Welle anliegendes Drehmoment zu ermitteln.

Die Auswerteeinheit kann weiterhin dazu ausgebildet sein, den Einfluss eines äußeren Störmagnetfelds auf die Ermittlung des Drehmoments aus den Signalen vom ersten und zweiten 3D-AMR-Sensor zu kompensieren, insbesondere in Echtzeit bei einer Änderung des Störmagnetfelds und/oder Messwertabweichungen aufgrund einer Rotationsasymmetrie der magnetisierten Abschnitte der Welle während einer Drehung der Welle um deren Längsachse zu kompensieren.

Das äußere Störmagnetfeld kann das Erdmagnetfeld und/oder ein Magnetfeld sein, das durch eine durch das Erdmagnetfeld hervorgerufene Magnetisierung der Welle erzeugt wird und/oder ein durch einen Permanentmagneten in der Nähe des 3D-AMR-Sensor erzeugtes Magnetfeld.

Durch die Verrechnung der Informationen (Magnetfeldstärken) welche man aus den 3 Achsen x, y, z des 3D-AMR-Sensors erhält lässt sich zusätzliche Information gewinnen, die zur Kompensation der RSU (Rotational Signal Uniformity) verwendet werden kann. Die RSU bezeichnet die Signaländerung welche bei der Drehung einer Welle um 360° in Längsachse entsteht. Diese Signaländerung begründet sich in einer nicht-idealen Magnetisierung des axialen Bereichs in Umfangsrichtung, was zu einer Rotationsasymmetrie der Sensorsignale bei einer Drehung der Welle um die Wellenachse führt. Bei einer idealen Magnetisierung wäre das gemessene Magnetfeld und somit das Sensorsignal unabhängig von der Winkelstellung der Welle und nur vom anliegenden Drehmoment abhängig.

Auf diese Weise können alternativ dazu oder zusätzlich auch Einflüsse eines ferromagnetischen Materials (z.B. eines Sensorgehäuses) kompensiert werden.

In einer anderen Weiterbildung kann die Auswerteeinheit einen Datenspeicher umfassen, in dem ein Zusammenhang zwischen dem gemessenen Magnetfeld und dem an der Welle anliegenden Drehmoment abgespeichert ist.

Der Zusammenhang kann darin als tabellarischer Zusammenhang oder als funktionaler Zusammenhang abgespeichert sein. Dazu kann der Drehmomentsensor vor der Inbetriebnahme kalibriert worden sein, indem bei bekanntem Drehmoment die entsprechenden Magnetfeldstärken gemessen werden. Der funktionale Zusammenhang kann beispielsweise eine lineare Funktion sein, die das gemessene Magnetfeld auf das anliegende Drehmoment abbildet.

Die oben genannte Aufgabe wird ebenfalls durch ein Verfahren nach Anspruch 10 gelöst.

Das erfindungsgenmäße Verfahren ist zur Ermittlung eines an einer Welle anliegenden Drehmoments geeignet, wobei die Welle in einem ersten axialen Abschnitt in einer ersten Umfangsrichtung magnetisiert ist und ein erste 3D-AMR-Sensor vorgesehen, wobei das Verfahren die folgenden Schritte umfasst: Anlegen eines Drehmoments an die Welle; Erfassen eines durch den ersten Abschnitt der Welle erzeugten Magnetfelds mit dem ersten 3D-AMR-Sensor; Ermitteln des anliegenden Drehmoments aus dem vom ersten 3D-AMR-Sensor erfassten Magnetfeld.

Die Welle weist einen zweiten axialen Abschnitt auf, der in einer zweiten Umfangsrichtung magnetisiert ist, die gegenläufig zur ersten Umfangsrichtung ist, und ein zweiter 3D-AMR-Sensor vorgesehen ist, wobei das Verfahren die folgenden Schritte umfasst: Erfassen eines durch den zweiten Abschnitt der Welle erzeugten Magnetfelds mit dem zweiten 3D-AMR-Sensor; Ermitteln des anliegenden Drehmoments aus dem vom ersten 3D-AMR-Sensor erfassten Magnetfeld und aus dem vom zweiten 3D-AMR-Sensor erfassten Magnetfeld.

Dabei kann die Ermittlung des anliegenden Drehmoments ein Korrigieren eines Messwertfehlers aufgrund eines in beiden 3D-AMR-Sensoren erfassten, vom Drehmoment unabhängigen Magnetfelds, insbesondere des Erdmagnetfelds, umfassen.

Vorzugsweise erfolgt das Korrigieren bei jedem Ermitteln des anliegenden Drehmoments, um das Korrigieren insbesondere bei einer Änderung des vom Drehmoment unabhängigen Magnetfelds durchzuführen.

Die genannten Weiterbildungen können einzeln eingesetzt oder wie beansprucht geeignet miteinander kombiniert werden.

Weitere Merkmale und beispielhafte Ausführungsformen sowie Vorteile der vorliegenden Erfindung werden nachfolgend anhand der Zeichnungen näher erläutert.

### Kurzbeschreibung der Zeichnungen

- Fig. 1: zeigt eine Ausführungsform des erfindungsgemäßen Drehmomentsensors.
- Fig. 2: zeigt einen Ausschnitt einer zweiten Ausführungsform des erfindungsgemäßen Drehmomentsensors.

### Ausführungsformen

Die vorliegende Erfindung betrifft einen Aufbau zur magnetoelastischen Messung von Drehmoment, welcher aus einer magnetisch codierten Welle, zwei 3D-AMR-Sensoren und einem Gehäuse an dem die Sensoren angebracht werden, zusammengesetzt ist. Die Erfindung betrifft weiterhin ein Verfahren zur magnetoelastischen Messung von Drehmoment. Zur Messung wird die primäre Messgröße, das Drehmoment, durch die magnetische Codierung der Welle in eine Änderung des Magnetfelds gewandelt. Diese Magnetfeldänderung wird dann mittels AMR-Sensoren gemessen und mit Algorithmen, die in Software implementiert sind, auf das Drehmoment zurückgeschlossen.

Durch das Messen mit 3D-AMR-Sensoren, welche 3 empfindliche Achsen besitzen, kann die Magnetfeldänderung unter Drehmoment in 3 Richtungen erfasst werden. Es kommen in der bevorzugten Ausführungsform zwei 3D-AMR-Sensoren zum Einsatz, die zusammen mit einer Auswerteelektronik an einem Gehäuse in Relation zu den Magnetfeldern der Messwelle angebracht werden.

Ein solcher magnetoelastischer Drehmomentsensor basiert auf einer Umkehrung des physikalischen Effekts der Magnetostriktion (Deformation magnetischer Materialien durch ein angelegtes magnetisches Feld), wobei ein auf die magnetisierte Welle einwirkendes Drehmoment eine Torsion der Welle hervorruft und als Folge davon eine Veränderung des Magnetfeldes außerhalb der Welle bewirkt. Diese Veränderung ist sehr empfindlich gegenüber der Größe des Drehmoments und kann mit dem Magnetfeldsensor gemessen werden.

Ein AMR-Sensor ist ein Magnetfeldsensor, der basierend auf dem anisotropen magnetoresistiven Effekt (AMR-Effekt) die Magnetfeldstärke messen kann. Dabei wird eine Abhängigkeit des elektrischen Widerstands von dem Winkel zwischen der Stromrichtung und der Magnetisierung in der Ebene der AMR-Schicht des AMR-Sensors ausgenutzt. Unter dem Einfluss eines externen Magnetfelds ändert sich die Richtung der Magnetisierung in der AMR-Schicht. Diese Änderung wird zur Messung des externen Magnetfeldes eingesetzt. Im Falle des hier verwendeten 3D-AMR-Sensors werden mehrere AMR-Schichten so angeordnet und verschaltet, dass das Magnetfeld auch in der dritten Dimension senkrecht zu den Schichten gemessen wird. Dadurch kann die Stärke des externen Magnetfeldes in 3D gemessen werden.

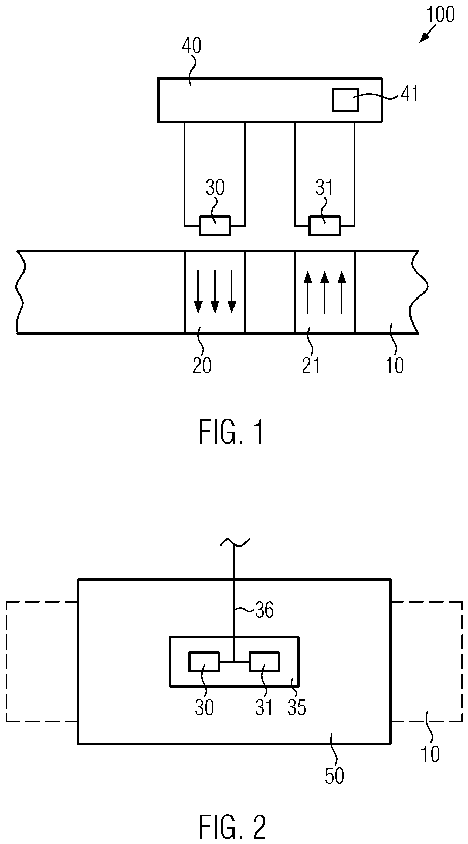

In Fig. 1 ist eine Ausführungsform 100 des erfindungsgemäßen Drehmomentsensors dargestellt.

Der erfindungsgemäße Drehmomentsensor 100 umfasst in dieser Ausführungsform eine Welle 10, die in einem ersten axialen Abschnitt 20 in einer ersten Umfangsrichtung magnetisiert ist, und an die ein zu messendes Drehmoment anlegbar ist; einen ersten 3D-AMR-Sensor 30 zum Erfassen eines durch den ersten Abschnitt 20 der Welle 10 erzeugten, vom angelegten Drehmoment abhängigen Magnetfelds außerhalb der Welle 10.

Die Welle 10 weist einen zweiten axialen Abschnitt 21 auf, der in einer zweiten Umfangsrichtung magnetisiert ist, die gegenläufig zur ersten Umfangsrichtung ist. Zudem umfasst der Drehmomentsensor 100 weiterhin einen zweiten 3D-AMR-Sensor 31 zum Erfassen eines durch den zweiten Abschnitt 21 der Welle 10 erzeugten, vom angelegten Drehmoment abhängigen Magnetfelds außerhalb der Welle 10.

An die Welle 10 kann ein zu messendes Drehmoment angelegt werden. Die Signale von den 3D-AMR-Sensoren werden zu einer Auswerteeinheit 40 geführt, die aufgrund der gemessenen Magnetfeldstärken die Größe des angelegten Drehmoments ermittelt. Dazu ist in der Auswerteeinheit ein Datenspeicher 41 enthalten, in dem ein vorbestimmter Zusammenhang zwischen der gemessenen Magnetfeldstärke und dem anliegenden Drehmoment gespeichert ist.

Fig. 2 zeigt einen Ausschnitt einer zweiten Ausführungsform des erfindungsgemäßen Drehmomentsensors. Der Unterschied zur ersten Ausführungsform besteht darin, dass die 3D-AMR-Sensoren gemeinsam auf einer Platine 35 angeordnet sind, die wiederum in einem Gehäuse 50 (z.B. ein Kunststoffgehäuse 50) gehaltert wird. Durch die Verwendung von Kunststoff wird der Einfluss von Störmagnetfeldern aufgrund einer Gehäusemagnetisierung reduziert bzw. eliminiert. Signalleitungen 36 führen von der Platine 35 durch das Gehäuse 50 zur Auswerteeinheit 40. Die Welle 10 ist in Fig. 2 nur gestrichelt angedeutet.

Einsatzgebiete des erfindungsgemäßen Drehmomentsensors sind beispielhaft im Folgenden aufgeführt:
- Ebike-Sensoren (einseitige Messung, beidseitig im Tretlager, Integriert in kundenspezifische Lösung für Mittelmotoren, Heckantrieb oder andere Antriebe)
- Drehmomentsensoren für Prüfstände im allgemeinen (E-Motorenprüfstände, Spezialanwendungen für hochdrehende Wellen)
- Robotik Anwendungen zur Messung des Drehmoments in angetriebenen Gelenken
- Medizintechnik (Kraftmessung an Lastkardanen) und Lastmessbolzen für Off-Highway Fahrzeuge mit Auslegern
- Windkraft (Sensoren zur Pitch- und Azimutverstellung)
- Agrartechnik (Getriebe Ein- und Ausgang, neben An- und Abtriebe)
- Motorsport (Messung an Gelenkwellen, Getriebeeingang, -ausgang, Messung in Hohlwellen, Messung im Ausrückerlager)
- Extruder (Messung des Drehmoments vor den Extrusionsschnecken)
- Richtmaschinen (Erfassung von Überlastung der Getriebe und Wellenpaketen)
- Luftfahrt (Getriebe Ein- und Ausgang, Aktuatoren, Antriebswelle Fan- und Propshaft)

Die Vorteile der erfindungsgemäßen Lösung sind dabei jeweils die Genauigkeit der Drehmomentmessung, insbesondere aufgrund der Korrektur der Einflüsse von Störfeldern, und der geringen Größe des dafür erforderlichen Bauraums. Weitere Vorteile sind:
- Geringerer Stromverbrauch: Durch den geringeren Stromverbrauch sind neue Anwendungsgebiete wie z.B. Tretlagereinheit zur Leistungsmessung denkbar. Diese könnten z.B. als Nachrüstlösung mit kleiner Batterie ("Knopfzelle") und drahtloser Datenübertragung ausgestaltet sein.
- Höhere Robustheit, dadurch dass SMD Bauelemente (oberflächenmontierte Bauelemente) verwendet werden können.
- Geringere Systemkomplexität in Bezug auf die elektronische Verschaltung und die Anzahl der Bauteile.

Die dargestellten Ausführungsformen sind lediglich beispielhaft und der vollständige Umfang der vorliegenden Erfindung wird durch die Ansprüche definiert.

## Patentansprüche

1. Magnetoelastischer Drehmomentsensor (100), umfassend:
eine Welle (10), die in einem ersten axialen Abschnitt (20) in einer ersten Umfangsrichtung magnetisiert ist, und an die ein zu messendes Drehmoment anlegbar ist;
wobei die Welle (10) einen zweiten axialen Abschnitt (21) aufweist, der in einer zweiten Umfangsrichtung magnetisiert ist, die gegenläufig zur ersten Umfangsrichtung ist;
einen ersten Magnetfeldsensor (30) zum Erfassen eines durch den ersten Abschnitt der Welle erzeugten, vom angelegten Drehmoment abhängigen Magnetfelds außerhalb der Welle;
einen zweiten Magnetfeldsensor (31) zum Erfassen eines durch den zweiten Abschnitt der Welle erzeugten, vom angelegten Drehmoment abhängigen Magnetfelds außerhalb der Welle;
**dadurch gekennzeichnet, dass**
der erste Magnetfeldsensor einen ersten 3D-AMR-Sensor (30) und der zweite Magnetfeldsensor einen zweiten 3D-AMR-Sensor (31) umfasst;
der magnetoelastische Drehmomentsensor weiterhin eine Auswerteeinheit (40) umfasst, die dazu ausgebildet ist, Sensorsignale von den 3D-AMR-Sensoren (30, 31) zu empfangen und aus den empfangenen Sensorsignalen ein an der Welle anliegendes Drehmoment zu ermitteln; und
wobei die Auswerteeinheit (40) weiterhin dazu ausgebildet ist, Messwertabweichungen aufgrund einer Rotationsasymmetrie der magnetisierten Abschnitte (20, 21) der Welle während einer Drehung der Welle um deren Längsachse zu kompensieren.

2. Magnetoelastischer Drehmomentsensor nach Anspruch 1, wobei ein oder mehrere weitere magnetisierte Wellenabschnitte mit einem oder mehreren 3D-AMR-Sensoren vorgesehen sind.

3. Magnetoelastischer Drehmomentsensor nach einem der Ansprüche 1 bis 2, wobei der erste 3D-AMR-Sensor und/oder der zweite 3D-AMR-Sensor und/oder jeder weitere 3D-AMR-Sensor mittels einer Kunststoffhalterung gehaltert sind.

4. Magnetoelastischer Drehmomentsensor nach einem der Ansprüche 1 bis 3, wobei der erste 3D-AMR-Sensor und/oder der zweite 3D-AMR-Sensor und/oder jeder weitere 3D-AMR-Sensor an oder in einem jeweiligen Gehäuse vorgesehen sind, oder wobei die 3D-AMR-Sensoren an oder in einem gemeinsamen Gehäuse (50) vorgesehen sind.

5. Magnetoelastischer Drehmomentsensor nach Anspruch 4, wobei das Gehäuse ein Kunststoffgehäuse umfasst.

6. Magnetoelastischer Drehmomentsensor nach einem der Ansprüche 1 bis 5, wobei die durch den 3D-AMR-Sensor bzw. die 3D-AMR-Sensoren zu messenden Magnetfeldstärken im Bereich von ± 10 mT, ± 3 mT, ± 1 mT, ± 300 µT, oder ± 100 µT liegen.

7. Magnetoelastischer Drehmomentsensor nach einem der Ansprüche 1 bis 6, wobei die Auswerteeinheit einen Datenspeicher (41) umfasst, in dem ein Zusammenhang zwischen dem gemessenen Magnetfeld und dem an der Welle anliegenden Drehmoment abgespeichert ist.

8. Magnetoelastischer Drehmomentsensor nach Anspruch 7, wobei der Zusammenhang als tabellarischer oder als funktionaler Zusammenhang abgespeichert ist.

9. Vorrichtung, die einen magnetoelastischer Drehmomentsensor nach einem der Ansprüche 1 bis 8 umfasst, wobei die Vorrichtung ein Tretlager eines Fahrrads oder eines E-Bikes, ein Motor, ein Motorprüfstand, ein Prüfstand für hochdrehende Wellen mit über 10.000 U/min., ein Getriebe, ein Roboter, ein Extruder, eine Richtmaschine, ein Flugzeug, ein Aktuator, eine Kardanwelle oder eine Antriebswelle ist.

10. Verfahren zur Ermittlung eines an einer Welle (10) anliegenden Drehmoments, wobei die Welle in einem ersten axialen Abschnitt (20) in einer ersten Umfangsrichtung magnetisiert ist und ein erster 3D-AMR-Sensor (30) vorgesehen ist, und wobei die Welle in einem zweiten axialen Abschnitt (21) in einer zweiten Umfangsrichtung magnetisiert ist, die gegenläufig zur ersten Umfangsrichtung ist, und ein zweiter 3D-AMR-Sensor (31) vorgesehen ist, wobei das Verfahren die folgenden Schritte umfasst:
Anlegen eines Drehmoments an die Welle;
Erfassen eines durch den ersten Abschnitt der Welle erzeugten Magnetfelds mit dem ersten 3D-AMR-Sensor;
Ermitteln des anliegenden Drehmoments aus dem vom ersten 3D-AMR-Sensor erfassten Magnetfeld;
Erfassen eines durch den zweiten Abschnitt der Welle erzeugten Magnetfelds mit dem zweiten 3D-AMR-Sensor;
Ermitteln des anliegenden Drehmoments aus dem vom ersten 3D-AMR-Sensor erfassten Magnetfeld und aus dem vom zweiten 3D-AMR-Sensor erfassten Magnetfeld;
Empfangen von Sensorsignalen von den 3D-AMR-Sensoren und Ermitteln eines an der Welle anliegenden Drehmoments aus den empfangenen Sensorsignalen durch eine Auswerteeinheit (40); und
Kompensieren von Messwertabweichungen aufgrund einer Rotationsasymmetrie der magnetisierten Abschnitte der Welle während einer Drehung der Welle um deren Längsachse durch die Auswerteeinheit.

11. Verfahren nach Anspruch 10, wobei die Ermittlung des anliegenden Drehmoments ein Korrigieren eines in beiden 3D-AMR-Sensoren erfassten, vom Drehmoment unabhängigen Magnetfelds umfasst.

12. Verfahren nach Anspruch 11, wobei das Korrigieren bei jedem Ermitteln des anliegenden Drehmoments erfolgt, um das Korrigieren bei einer Änderung des vom Drehmoment unabhängigen Magnetfelds durchzuführen.

## Claims

1. Magnetoelastic torque sensor (100), comprising:
a shaft (10) that is magnetized in a first axial section (20) in a first circumferential direction and to which a torque to be measured can be applied;
wherein the shaft (20) has a second axial section (21) that is magnetized in a second circumferential direction that is opposed to the first circumferential direction;
a first magnetic field sensor (30) for recording of a magnetic field, which is generated by the first section of the shaft and which is dependent on the applied torque, outside of the shaft;
a second magnetic field sensor (31) for recording of a magnetic field, which is generated by the second section of the shaft and which depends on the applied torque, outside of the shaft;
**characterized in that**
the first magnetic field sensor comprises a first 3D-AMR sensor (30) and the second magnetic field sensor comprises a second 3D-AMR sensor (31);
the magnetoelastic torque sensor further comprises an evaluation unit (40) that is configured to receive sensor signals from the 3D-AMR sensors (30, 31) and to determine a torque applied to the shaft out of the received sensor signals; and
wherein the evaluation unit is (40) further configured to compensate measurement value deviations due to a rotation asymmetry of the magnetized sections (20, 21) of the shaft during a rotation of the shaft around its longitudinal axis.

2. Magnetoelastic torque sensor according to Claim 1, wherein one or multiple magnetized shaft sections with one or multiple 3D-AMR sensors are provided.

3. Magnetoelastic torque sensor according to one of the Claims 1 to 2, wherein the first 3D-AMR sensor and/or the second 3D-AMR sensor and/or every further 3D-AMR sensor are held by means of a plastic holder.

4. Magnetoelastic torque sensor according to one of the Claims 1 to 3, wherein the first 3D-AMR sensor and/or the second 3D-AMR sensor and/or every further 3D-AMR sensor are provided on or in a respective housing or wherein the 3D-AMR sensors are provided on or in a joint housing (50).

5. Magnetoelastic torque sensor according to Claim 4, wherein the housing comprises a plastic housing.

6. Magnetoelastic torque sensor according to one of the Claims 1 to 5, wherein the magnetic field strengths to be measured by the 3D-AMR sensor and/or the 3D-AMR sensors are in the range of ±10mT, ±3mT, ±1mT, ±300µT or ±100µT.

7. Magnetoelastic torque sensor according to one of the Claims 1 to, wherein the evaluation unit comprises a data memory (41) in which a link between the measured magnetic field and the torque applied to the shaft is saved.

8. Magnetoelastic torque sensor according to Claim 7, wherein the link is saved as a tabular relation or a functional relation.

9. Device that comprises a magnetoelastic torque sensor according to one of the Claims 1 to 8, wherein the device is a bottom bracket of a bicycle or an e-bike, a motor, a motor test facility, a test facility for high-speed shafts with over 10,000 rpm, a gearbox, a robot, an extruder, a straightening machine, a plane, an actuator, a cardan shaft or a drive shaft.

10. Method for determining a torque applied to a shaft (10), wherein the shaft is magnetized in a first axial section (20) in a first circumferential direction and a first 3D-AMR sensor (30) is provided, and wherein the shaft is magnetized in a second axial section (21) in a second circumferential direction that is opposed to the first circumferential direction and wherein a second 3D-AMR sensor (31) is provided, wherein the method comprises the following steps:
application of a torque to the shaft;
recording a magnetic field generated by the first section of the shaft, by means of the first 3D-AMR sensor;
determining the applied torque out of the magnetic field recorded by the first 3D-AMR sensor;
recording a magnetic field generated by the second section of the shaft, by means of the second 3D-AMR sensor;
determining the applied torque out of the magnetic field recorded by the first 3D-AMR sensor and out of the magnetic field recorded by the second 3D-AMR sensor;
receiving sensor signals from the 3D-AMR sensors and determining a torque applied to the shaft out of the received sensor signals by an evaluation unit (40); and
compensating measurement value deviations due to a rotation asymmetry of the magnetized sections of the shaft during a rotation of the shaft around its longitudinal axis by the evaluation unit.

11. Method according to Claim 10, wherein the determining of the applied torque comprises a correction of a magnetic field, which is recorded in both 3D-AMR sensors and independent of the torque.

12. Method according to Claim 11, wherein the correction takes place for each determination of the applied torque in order to perform the correction in case of a change of the magnetic field that is independent of the torque.

## Revendications

1. Capteur magnéto-élastique de couple de rotation (100) comprenant:
un arbre (10) magnétisé dans une première partie axiale (20) dans une première direction circonférentielle, et auquel un couple à mesurer peut être appliqué;
ledit arbre (10) ayant une seconde partie axiale (21) magnétisée dans une seconde direction circonférentielle opposée à ladite première direction circonférentielle;
un premier capteur de champ magnétique (30) pour détecter un champ magnétique généré par la première partie de l'arbre à l'extérieur de l'arbre et dépendant du couple appliqué;
un second capteur de champ magnétique (31) pour détecter un champ magnétique dépendant du couple généré par la seconde partie de l'arbre à l'extérieur de l'arbre;
**caractérisé en ce que**
ledit premier capteur de champ magnétique comprend un premier capteur AMR 3D (30) et ledit second capteur de champ magnétique comprend un second capteur AMR 3D (31);
le capteur magnéto-élastique de couple de rotation comprend en outre une unité d'évaluation (40) qui est conçue pour recevoir des signaux de capteur provenant des capteurs 3D-AMR (30, 31) et pour déterminer un couple appliqué à l'arbre à partir des signaux de capteur reçus; et
dans lequel l'unité d'évaluation (40) est en outre adaptée pour compenser les écarts de valeurs de mesure dus à l'asymétrie de rotation des sections magnétisées (20, 21) de l'arbre pendant la rotation de l'arbre autour de son axe longitudinal.

2. Capteur magnéto-élastique de couple de rotation selon la revendication 1, dans lequel une ou plusieurs autres sections d'arbre magnétisées sont pourvues d'un ou plusieurs capteurs 3D-AMR.

3. Capteur magnéto-élastique de couple de rotation selon l'une quelconque des revendications 1 à 2, dans lequel le premier capteur 3D-AMR et/ou le second capteur 3D-AMR et/ou chaque autre capteur 3D-AMR sont supportés au moyen d'un support en matière plastique.

4. Capteur magnéto-élastique de couple de rotation selon l'une des revendications 1 à 3, dans lequel le premier capteur 3D-AMR et/ou le second capteur 3D-AMR et/ou chaque autre capteur 3D-AMR sont prévus sur ou dans un boîtier respectif, ou dans lequel les capteurs 3D-AMR sont prévus sur ou dans un boîtier commun (50).

5. Capteur magnéto-élastique de couple de rotation selon la revendication 4, dans lequel le boîtier comprend un boîtier en matière plastique.

6. Capteur magnéto-élastique de couple de rotation selon l'une quelconque des reven-dications 1 à 5, dans lequel les intensités de champ magnétique à mesurer par le ou les capteurs 3D-AMR sont dans la plage de ± 10 mT, ± 3 mT, ± 1 mT, ± 300 µT ou ± 100 µT.

7. Capteur magnéto-élastique de couple de rotation selon l'une des revendications 1 à 6, dans lequel l'unité d'évaluation comprend une mémoire de données (41) dans laquelle est mémorisée une relation entre le champ magnétique mesuré et le couple appliqué à l'arbre.

8. Capteur magnéto-élastique de couple de rotation selon la revendication 7, dans lequel la relation est mémorisée sous forme de tableau ou de relation fonctionnelle.

9. Dispositif comprenant un capteur magnéto-élastique de couple de rotation selon l'une des revendications 1 à 8, dans lequel le dispositif est un palier de pédalier d'une bicyclette ou d'un vélo électrique, un moteur, un banc d'essai de moteur, un banc d'essai pour arbres à grande vitesse avec plus de 10.000 tr/min, une boîte de vitesses, un robot, une extrudeuse, une machine à redresser, un avion, un actionneur, un arbre à cardan ou un arbre d'entraînement.

10. Procédé pour détecter un couple de rotation appliqué à un arbre (10), dans lequel l'arbre est magnétisé dans une première partie axiale (20) dans une première direction circonférentielle et un premier capteur AMR 3D (30) est prévu, et dans lequel l'arbre est magnétisé dans une seconde partie axiale (21) dans une seconde direction circonférentielle opposée à la première direction circonférentielle et un second capteur AMR 3D (31) est prévu, le procédé comprenant les étapes suivantes:
appliquer un couple à l'arbre;
détecter un champ magnétique généré par la première partie de l'arbre avec le premier capteur AMR 3D;
déterminer le couple appliqué à partir du champ magnétique détecté par le premier capteur AMR 3D;
détecter un champ magnétique généré par la seconde partie de l'arbre avec le second capteur 3D-AMR;
déterminer le couple appliqué à partir du champ magnétique détecté par le premier capteur 3D-AMR et du champ magnétique détecté par le second capteur 3D-AMR;
recevoir des signaux de capteur des capteurs 3D-AMR et déterminer un couple appliqué à l'arbre à partir des signaux de capteur reçus par une unité d'évaluation (40); et
compenser les écarts de valeurs de mesure dus à l'asymétrie de rotation des sections magnétisées de l'arbre lors de la rotation de l'arbre autour de son axe longitudinal.

11. Procédé selon la revendication 10, dans lequel la détermination du couple appliqué comprend la correction d'un champ magnétique détecté dans les deux capteurs 3D-AMR qui est indépendant du couple.

12. Procédé selon la revendication 11, dans lequel la correction est effectuée à chaque fois que le couple appliqué est déterminé, afin d'effectuer la correction en cas de changement du champ magnétique indépendant du couple.
